# EUROPEAN PATENT APPLICATION

(11) **EP 4 412 006 A2**
(43) Date of publication of application: **07.08.2024**
(21) Application number: 23197335.5
(22) Date of filing: 14.09.2023
(51) Int. Cl.: H01S 5/0687, G04F 5/14, H03L 7/26

(54) **FREQUENCY AGILE LASER SYSTEM LOCKED TO AN ATOMIC REFERENCE**

(30) Priority: 15.11.2022 US 202218055452
(71) Applicant: Vector Atomic, Inc., Pleasanton, CA 94566 (US)
(72) Inventor: CINGOZ, Arman, Pleasanton, 94566 (US); RAKHOLIA, Akash Vrijlal, Pleasanton, 94566 (US)
(74) Representative: Kehl, Ascherl, Liebhoff & Ettmayr Patentanwälte Partnerschaft mbB

(57) **Abstract**

Embodiments herein describe using a reference laser locked to an atomic reference to adjust the wavelength of a seed laser. A frequency adjuster (e.g., a frequency doubler) can adjust the seed laser to a different wavelength/frequency for a particular application. A controller can adjust the wavelength of the seed laser by comparing the reference laser to the adjusted seed laser generated by the frequency adjuster.

## Description

### BACKGROUND

### Field

Embodiments of the present invention generally relate to using atomic references to adjust optical systems.

### Description of the Related Art

A variety of laser-cooling atomic techniques are used both in academic and industrial settings to perform various atomic physics experiments and implement commercial sensors such as atomic gyroscopes, gravimeters, gravity gradiometers, magnetometers, clocks, and quantum computing devices. Regardless of the application, laser trapping, cooling, state preparation, and readout sequences require a laser source with sub-MHz linewidth, and can be tuned arbitrarily with GHz-level frequency agility that settles to desired frequencies deterministically within 500 microseconds. In high precision applications, the laser noise requirements are stricter, necessitating less than 10 kHz linewidth lasers, which limit the number of choices dramatically.

Often overlooked, but equally important characteristics are environmental robustness, lifetime, and autonomous operation of the laser system that are important for real-world applications, where sensors must operate in uncontrolled temperature and humidity environments unattended for months at a time. Relevant atomic transitions typically lie in the wavelength range from 400-800 nm. While direct semiconductor-based laser systems are available in many cases, and provide the smallest size and power footprint, the underlying components are "research-grade", lacking the robustness to operate in the field for extended durations. These lasers have short life spans, inconsistent performance from batch-to-batch, and are susceptible to mode hopes where the output frequency of the laser has a discrete and unrecoverable frequency jump to an adjacent longitudinal lasing mode at a given temperature and current.

As a result, an alternate approach is to use lasers, amplifiers, and modulators that have been developed by the telecommunication industry in the infrared, and then frequency double the output into the visible range used by laser-cooling atomic techniques. These telecommunication lasers provide robust and reliable operation, but absolute wavelength referencing and frequency agility requirements often require multiple frequency doubled paths and modulators, which add considerable cost and complexity to these systems.

### SUMMARY

One embodiment described herein is an optical system that includes a seed laser source configured to output a first optical signal with a first wavelength, a frequency adjuster configured to receive the first optical signal and output an adjusted first optical signal with a second wavelength, a reference laser source configured to output a second optical signal with a third wavelength, wherein the first wavelength is different than the third wavelength, an atomic reference configured to receive the second optical signal and output a control signal to the reference laser source that locks the second optical signal to the third wavelength, and a controller configured to adjust the first optical signal based on comparing the adjusted first optical signal to the second optical signal.

Another embodiment described herein is a method that includes generating, using an optical source, a first optical signal having a first wavelength, adjusting the wavelength of the first optical signal to generate an adjusted first optical signal having a second wavelength, comparing the adjusted first optical signal to a second optical signal, wherein the second optical signal is locked to an atomic reference at a third wavelength, and adjusting the optical source to change the first wavelength of the first optical signal based on comparing the adjusted first optical signal to the second optical signal.

Another embodiment described herein is a system that includes an input configured to receive an error signal indicating a difference between wavelengths of a first optical signal and a second optical signal, a control system configured to output instructions to perform a frequency jump to change a frequency of the first optical signal relative to a frequency of the second optical signal, a digital frequency counter configured to count frequency cycles of the error signal, a digital servo configured to generate an adjustment signal based on the frequency cycles counted by the digital frequency counter, and a feedforward path configured to generate an offset corresponding to a frequency value received from the control system. Further, the system is configured to use the offset from the feedforward path and the adjustment signal from the digital servo to output a modified adjustment signal for adjusting an optical source generating the first optical signal to perform the frequency jump.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope, may admit to other equally effective embodiments.
Figure 1 illustrates an optical system with different wavelength laser sources that are locked using an atomic reference, according to one embodiment.
Figure 2 is a flowchart for adjusting a first laser source using a second laser source locked to an atomic reference, according to one embodiment.
Figure 3 illustrates an optical system with different wavelength laser sources that are locked using an atomic reference, according to one embodiment.
Figure 4 illustrates frequency agility for a laser used for laser-cooling atomic techniques, according to one embodiment.
Figures 5A-5D are block diagrams for changing laser frequency using feed forwarding, according to one embodiment.
Figures 6A-6C illustrate advantages of changing laser frequency using feed forwarding, according to one embodiment.
Figure 7 illustrates an effect of feed forwarding on a laser frequency transition, according to one embodiment.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments herein describe using a reference laser locked to an atomic source to adjust the wavelength of a seed laser. As discussed above, laser sources for telecommunication applications (e.g., 1560 nm lasers) can be frequency doubled to provide optical signals used in laser-cooling atomic techniques (e.g., 780 nm lasers). However, high power lasers and optical amplification may be the main power consumption driver in the system, and the frequency doubling crystals are one of the major cost drivers. Thus, it is desirable to reduce the number of independent amplification and frequency doubling paths in the optical system. In one embodiment, the optical system can provide the frequency agility needed for laser-cooling atomic technique with a single optical amplification and doubling path, via offset locking the telecommunication system to a robust, low power semiconductor laser in the visible spectrum. For example, a high-power telecommunication laser (e.g., a 1560 nm laser) can be frequency doubled to output a 780 nm optical signal. This seed laser can then be adjusted to achieve the required frequency agility using a low-power reference laser (e.g., a 780 nm) that is locked to an atomic reference.

Further, the embodiments herein can use feedforward and feedback servo architectures in order to change the laser frequency quickly while ensuring the potentially noisier reference laser does not impact the linewidth of the seed laser.

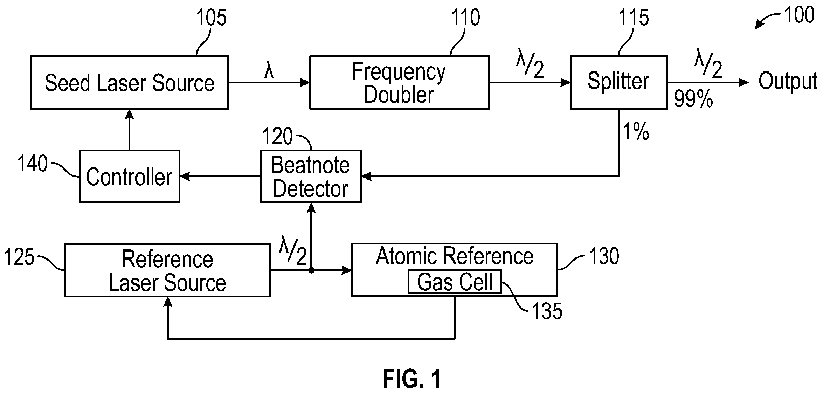

Figure 1 illustrates an optical system 100 with different wavelength laser sources that are locked using an atomic reference, according to one embodiment. That is, the optical system 100 includes a first laser source, referred to as the seed laser source 105 which outputs an optical signal with a first wavelength (λ) and a second laser source, referred to as the reference laser source 125, which outputs an optical signal with a second wavelength (λ/2) that is half the first wavelength.

In one implementation, the seed laser source outputs a 1560 nm optical signal (i.e., λ = 1560 nm) while the seed laser source 105 outputs a 780 nm optical signal (i.e., λ/2 = 780 nm), but this is just one example. The advantage of a 1560 nm seed laser source 105 is that this can be a telecommunication laser that can be high power (e.g., hundreds of milliwatts (mW)), reliable, offer consistent performance, and relatively low cost. Because the seed laser source 105 has these traits, it can be used in commercial implementations of the optical system 100 to perform high-power optical applications, such as laser-cooling atomic applicants for atomic sensors. In contrast, the 780 nm reference laser source 125 can be low power laser (e.g., 1-10 mW), research grade laser source. Although the laser source 125 may not be a commercial grade, because it operates at a much lower power than the seed laser source 105, it can have a similar reliability and life expectancy as a commercial seed laser source 105.

In this embodiment, the seed laser source 105 outputs a laser with a wavelength that is twice as long as the wavelength of the reference laser source 125, but the embodiments are not limited to such. For example, the reference laser source 125 may output an optical signal with a wavelength that is a fourth or an eighth of the wavelength of the seed laser source 105.

The optical system 100 includes a frequency doubler 110 that alters the wavelength (and the frequency) of the optical signal generated by the laser source 105 to substantially match the frequency of the reference laser source 125. In this example, the frequency doubler 110 reduces the wavelength by half (i.e., doubles the frequency), but in other embodiments, any type of frequency adjuster can be used that may reduce the wavelength by a fourth, eighth, etc. In general, the optical signal generated by the seed laser source 105 can have any wavelength or frequency that is an integer multiple of the wavelength or frequency of the optical signal generated by the reference laser source 125. A frequency adjuster (e.g., the frequency doubler 110) can then adjust the optical signal generated by the seed laser source 105 to have a frequency that is approximately the same (e.g., within a few GHz or within a few hundred MHz) of the frequency of the signal generated by the reference laser source 125. As discussed below, the frequency of the optical signal output by the frequency doubler 110 may intentionally be different (e.g., by a few GHz or MHz) than the frequency of the optical signal output by the reference laser source 125 when performing frequency changes as part of frequency agility. That is, the optical signal generated by the seed laser source 105 can have any wavelength or frequency that is approximately an integer multiple of the wavelength or frequency of the optical signal generated by the reference laser source 125 but can slightly different (e.g., +/- a few GHz or MHz) to enable frequency agility.

The optical signal output by the frequency doubler 110 is the output of the optical system 100. For example, the optical signal generated by the frequency doubler 110 may be used to cool atoms as part of a cold atomic sensor. In addition to being used in atomic sensors, the optical system 100 may also be used in other applications such as coherent LIDAR or in quantum computing.

However, before outputting the optical signal generated by the frequency doubler 110 to a downstream system (e.g., an atomic sensor or LIDAR), a splitter 115 redirects a portion of the power in the optical signal to a beatnote detector 120 while the remaining power is transmitted to the downstream system. In this embodiment, the splitter 115 is a 99/1 optical splitter where 1% of the optical power is transmitted to the beatnote detector 120 and 99% of the power is transmitted to the downstream system. However, other embodiments might include other splitting ratios such as 50/50.

The beatnote detector 120 receives two optical signals: one from the splitter 115 and another from the reference laser source 125. Although the seed laser source 105 may be a high-power laser while the reference laser source 125 is a low-power laser. Because the splitter 115 forwards only 1% of the optical power to the beatnote detector, the power of the optical signals received at the beatnote detector 120 from the laser sources 105, 125 may be approximately the same. However, this is not a requirement.

The beatnote detector 120 mixes the optical signals and forwards an electrical signal to the controller 140 representing the error or separation between the beat notes in the signals. That is, the beatnote detector 120 can forward an error signal to the controller indicating the difference between the wavelengths in the received optical signals. In one embodiment, the beatnote detector 120 includes a photodiode that detects and mixes the received optical signals.

The controller 140 receives the electrical error signal from the beatnote detector 120. The controller 140 can be hardware, software, or a combination thereof. For example, the controller 140 can be implemented using an application specific integrated circuit (ASIC) or a field programmable gate array (FPGA).

The controller 140 generates an adjustment signal in response to the error signal received from the beatnote detector 120. For example, if the controller 140 wants the optical signal generated by the seed laser source 105 and the frequency doubler 110 to have the same wavelength as the reference laser source 125, then the controller can adjust the parameters of the laser source 105 until the error signal generated by the beatnote detector 120 indicates the wavelengths of the two optical signals are the same. Thus, the optical system 100 can be used to ensure the wavelength of the optical signal output by the frequency doubler 110 precisely matches the wavelength of the optical signal generated by the reference laser source 125.

However, for laser-cooling atomic techniques, the optical system 100 is typically tasked with making small adjustments to the wavelength (and frequency) of the optical signal generated by the seed laser source 105. For example, a 1560 nm laser has a frequency of approximately 192 THz. The optical system 100 may change this frequency by a tens of MHz or KHz. Thus, these very small changes in frequency/wavelength demand very tight control of the laser source.

This tight control of the seed laser source 105 is enabled by locking the reference laser source 125 to an atomic reference 130. In this example, the atomic reference 130 includes a gas cell 135 (also referred to as a spectroscopy cell) used in laser spectroscopy. The type of gas cell 135 depends on the wavelength of the optical signal generated by the reference laser source 125, but for 780 nm optical signal, a rubidium gas cell 135 can be used. For example, when the wavelength of the reference laser source 125 is at a particular resonance frequency - i.e., 780 nm - the rubidium gas fluoresces which is detected by a photodetector in the atomic reference 130. The electrical output of the photodetector can be used in a feedback loop to then adjust the reference laser source 125 to lock the wavelength of its optical signal to the resonance frequency of the gas cell 135. In this manner, the atomic reference 130 establishes an absolute frequency reference for the optical system 100 where the wavelength of the reference laser source 125 is precisely controlled.

By locking the optical signal of the reference laser source to the atomic reference 130, the beatnote detector 120 can then generate an error signal that the controller 140 can use to make precise adjustments to the wavelength of the optical signal generated by the seed laser source 105. That is, by knowing that the reference laser source 125 is locked at a precise wavelength, the controller 140 and the beatnote detector 120 can compare its optical signal to the optical signal generated by the seed laser source 105 and the frequency doubler 110 to make sure it is either the same (when both signals should be locked together) or has the desired offset (when the output of the frequency doubler 110 should be offset by a few hundreds of MHz or KHz from the optical signal generated by the reference laser source 125 when outputting, e.g., a signal used for laser-cooling atomic applications). In this manner, the optical system 100 can perform very small and precise frequency transitions on the seed laser source 105. Being able to precisely control and transition the frequency of the optical signal generated by the seed laser source 105 is referred to as frequency agility.

The advantage of the optical system 100 over other solutions for enabling precise control of a laser source is that there is only one frequency doubler 110. Other solutions may use multiple frequency doublers, as well as include a modulator. This greatly increases the cost. Further, the reference laser source 125 can be a low power laser which increases its lifespan and reduces overall power consumption in the system 100.

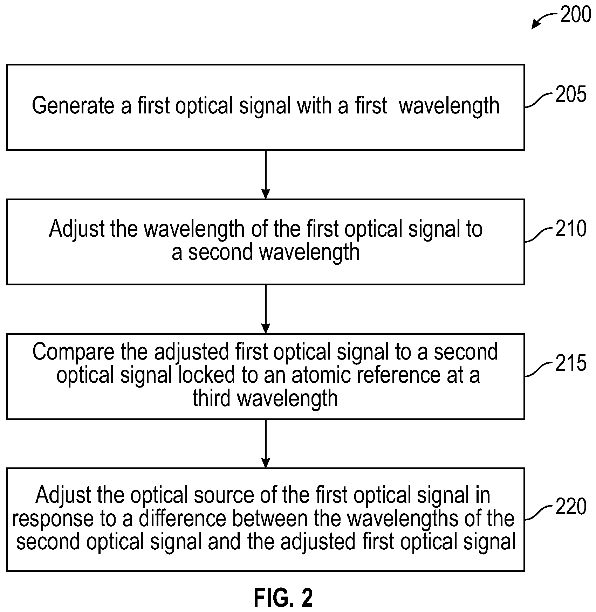

Figure 2 is a flowchart of a method 200 for adjusting a first laser source using a second laser source locked to an atomic reference, according to one embodiment. Specifically, the method 200 describes techniques for performing precise frequency transitions to a first optical signal using a second optical signal that is locked to an atomic reference. At block 205, a seed laser source generates the first optical signal that has a first wavelength.

At block 210, a frequency doubler adjusts the wavelength of the first optical signal to a second wavelength. That is, the frequency doubler can output an output signal with a wavelength that 1/2 of the wavelength of the first optical signal. Multiple frequency doublers can be cascaded to output signals with a wavelength that is 1/4 or 1/8 of the wavelength of the first optical signal. Thus, the method 200 assumes that the optical system includes at least one frequency doubler for changing the wavelength and frequency of the first optical signal, like the optical system 100 illustrated in Figure 1.

At block 215, a controller compares the adjusted first optical signal (which now has the second wavelength) to a second optical signal locked to an atomic reference at a third wavelength. Because the second optical signal is locked to an atomic reference, the controller knows the second optical signal is truly at the third wavelength. That is, the second optical signal serves as an absolute frequency reference for the optical signal. As discussed in Figure 1, a beatnote detector may be used to compare the adjusted first optical signal with the second optical signal.

At block 220, the controller adjusts the optical source of the first optical signal in response to a difference between the wavelengths of the second optical signal and the adjusted first optical signal. In one embodiment, the controller 140 adjusts the optical source of the first optical signal so that the wavelengths of the second optical signal and the adjusted first optical signal are the same. However, in other embodiments, the controller 140 adjusts the optical source of the first optical signal so that the wavelength of the adjust first optical signal has a desired offset from the wavelength of the second optical signal to support frequency agility. That is, the controller 140 may control the optical source so the frequency of the adjusted first optical signal is a few MHz or KHz different from the frequency of the second optical signal as part of a laser-cooling atomic application.

In one embodiment, at some times the controller adjusts the optical source so that the wavelengths of the adjusted first optical signal and the second optical signal match, but at other times there is a desired offset between their wavelengths/frequency. For example, a laser-cooling atomic application may use different frequency transitions at different stages. As a simplistic example, at Time A the controller adjusts the optical source so the wavelengths match, at Time B the controller adjusts the optical source so the adjusted first optical signal has a 500 MHz offset from the second optical signal, at Time C the controller adjusts the optical source so the adjusted first optical signal has a 100 MHz offset from the second optical signal, and at Time D the controller adjusts the optical source so the wavelengths again match.

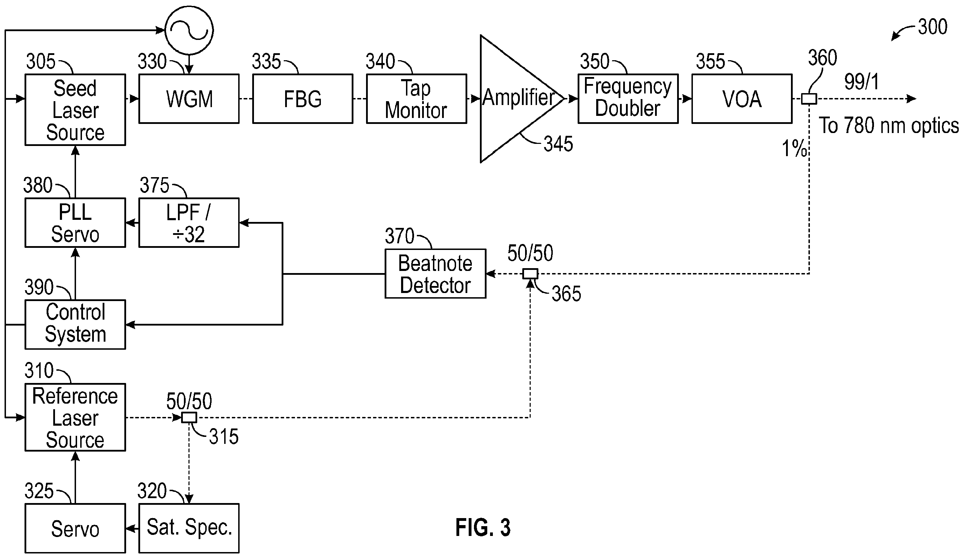

Figure 3 illustrates an optical system 300 with different wavelength laser sources that are locked using an atomic reference, according to one embodiment. In one embodiment, the optical system 300 is a more detailed description of the optical system 100 where a seed laser source 305 generates an optical signal with a different wavelength than a reference laser source 310.

In one embodiment, the reference laser source 310 is a 780 nm source, but the particular wavelength of the source 310 can depend on the application of the optical system 300. In one embodiment, the reference laser source 310 is intentionally de-rated in output power to increase the lifetime of the device. The reference laser source 310 can be a distributed feedback (DFB) or a distributed Bragg reflector (DBR) laser. For many applications, only a few mWs of optical power is sufficient for the operation of the system 300.

The output of the reference laser source 310 is split into two equal optical signals by a 50/50 splitter 315, but the split ratio can be adjusted depending on how much optical power is required on either output.

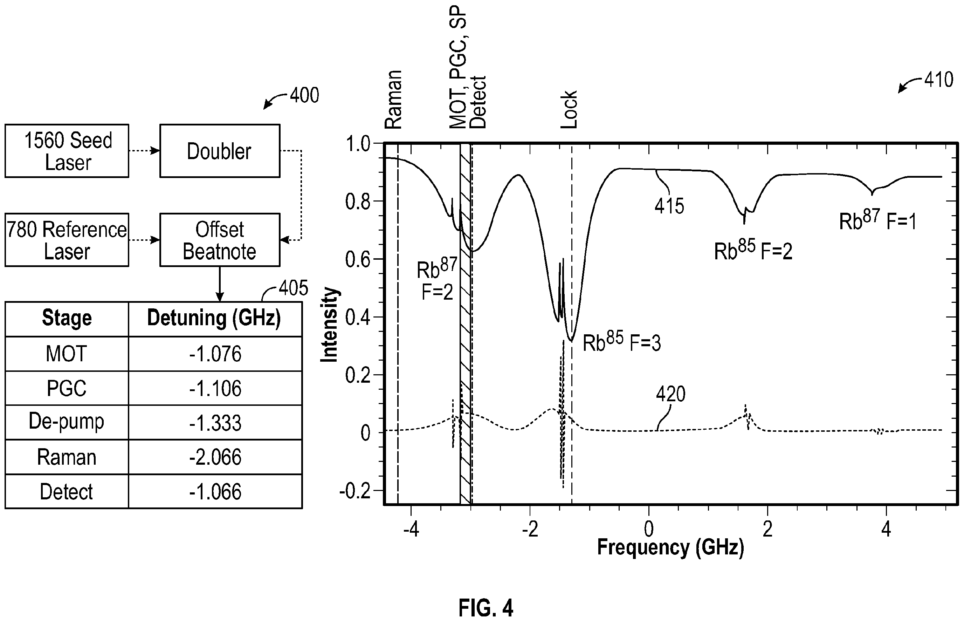

One output of the splitter 315 is transmitted to a saturated absorption spectrometer 320 (e.g., one example of the atomic reference 130 in Figure 1). The spectrometer 320 uses a photodetector to generate an error signal to stabilize the frequency of the optical signal output by the reference laser source 310. For a 780 nm optical signal, the source 310 can be locked to the F=3 to F'=4 ⁸⁵Rb transition such that the 780 nm optical signal is approximately 1 GHz blue detuned from the ⁸⁷Rb transitions used in various steps of a laser-cooling atomic sequence. That way, a doubled 1560 nm laser generated by the seed laser source 305 can be offset locked at various frequencies with respect to the 780 nm laser to provide frequency agility. A detailed description of the offset frequencies is provided in Figure 4.

The error signal generated by the spectrometer 320 is provided to a servo 325 (e.g., servo feedback circuitry) which generates a control signal to stabilize the absolute frequency of the reference laser source 310. In one embodiment, to minimize external components such as waveguide modulators, the servo 325 also provides a modulation signal directly to the laser current which is used to generate a modulation signal. The modulation frequency is typically a few MHz or larger, which is outside the servo bandwidth for both the 780 nm lock and the 1560 nm lock so that these modulation sidebands are not transferred to the 1560 nm signal generated by the seed laser source 305. That is, the lock that stabilizes the optical signal output by the seed reference source 305 to the optical signal output by the reference laser source 310 is not fast enough to follow this modulation signal so the seed optical signal does not acquire these modulation sidebands.

Turning to the seed laser source 305, its output is transmitted to a waveguide phase modulator (WGM) 330 which creates sidebands offset from the carrier frequency of the optical signal. These sidebands are useful in cases where multiple laser frequencies are required simultaneously. For laser-cooling atomic applications, the WGM 330 can be used for re-pumping and de-pumping during cooling, trapping, and state preparation, and also to generate Raman sideband during the interferometry sequence. However, if multiple frequencies are not simultaneously required then the WGM can be omitted.

A fiber Bragg grating (FBG) 335 can be used for atom interferometry as a bandpass filter to select the carrier frequency and the first blue sideband generated by the WGM 330. Doing so provides power savings (otherwise around 30% of the frequency doubled optical signal is at an unwanted frequency) and minimizes certain systematics associated with an interferometer. However, if the optical system 300 is not being used for atom interferometry, then the FBG 335 may be omitted.

A tap monitor 340 (e.g., a fiber optic tap monitor) receives the optical signal and redirects a small amount of the optical signal (e.g., 1% of the optical power) for monitoring the power of the optical signal generated by the seed laser source 305. This monitoring signal can be used both as an interlock safety signal which shuts down an optical amplifier 345 if the seed laser source 305 is not active, and can be used during a laser-cooling atomic sequence to ensure the seed power is constant as the laser frequency is changed by feeding back onto the RF drive of the WGM 330, which is discussed below.

The optical amplifier 345 (e.g., an Erbium doped fiber amplifier) then amplifies the optical signal. In one embodiment, the amplifier 345 increases the optical signal to 1W in order to generate an optical signal with at least 500mW after passing the optical signal through a frequency doubler 350. For example, the frequency doubler 350 may receive a 1W 1560nm optical signal and output a 500mW (or greater) 780nm optical signal.

A variable optical attenuator (VOA) 355 controls the power of the frequency doubled optical signal and can be combined with a monitor detector further downstream to actively stabilize the optical power.

A splitter 360 transmits a small percentage of the power of the frequency doubled optical signal (e.g., 1% in this example) to a coupler 365 (e.g., a 50/50 coupler) where it is combined with the second output of the splitter 315. The optical interference between the two optical signals is detected with a photodetector in a beatnote detector 370.

An electrical error signal generated by the beatnote detector 370 can be used to detect the offset beatnote between the optical signal generated by reference laser source 310 and the doubled main path carrier optical signal generated by the frequency doubler 350. This is performed by a control system 390. The control system 390 can then generate adjustment signals for the reference laser source 310, the seed laser source 305, and the signal generator for the WGM 330. Using the example above, the reference laser can be stabilized to ⁸⁵Rb F=3 to F'=4 transition such that it is 1 GHz blue detuned with respect to the ⁸⁷Rb cycling transition. As a result, the beatnote frequency between the two optical signals range from approximately 1 - 2 GHz depending on the specific task in the laser-cooling atomic sequence.

The second task is further processing the raw beatnote frequency to stabilize the main laser path at the desired offset frequency. In one embodiment, the electrical signal generated by the beatnote detector 370 is filtered to isolate the carrier beatnote and divided down using a frequency divider 375 to reduce the beatnote frequency to a more manageable value for digital circuitry. In this example a divide by 32 is chosen to reduce the beatnote frequency to the 30-60 MHz range, but it can be higher or lower value depending on the selected servo components in a phase locked loop (PLL) servo 380. A relatively high division value may be desirable since this also divides down the excess frequency noise of a 780 nm reference optical signal so that it is much less apparent in the divided down beatnote. This is especially beneficial in laser-cooling atomic techniques, since it is undesirable for the narrow linewidth 1560 nm optical signal generated by a "commercial grade" seed laser source 305 to follow the excess frequency noise generated by a "research grade" reference laser source 310.

In one embodiment, the 30-60 MHz tone generated by the frequency divider 375 is sampled using a digital to analog converter and further processed in the PLL servo 380 (which can be implemented on an ASIC or a FPGA). In the PLL servo 380, phase sensitive detection and a digital servo electronics generate a phase-locked loop to stabilize the main optical signal generated by the seed laser source 305 to the optical signal generated by the reference laser source 310 at a precise frequency offset for performing frequency agility.

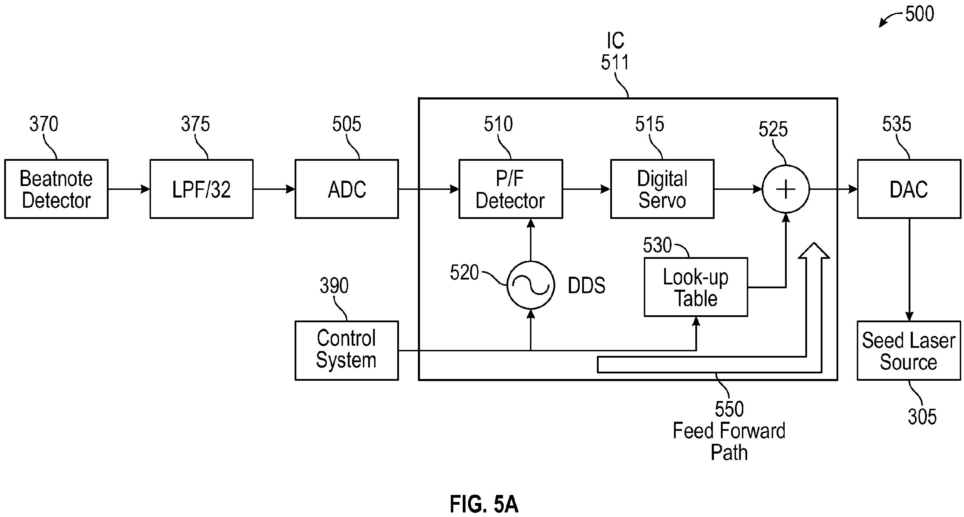

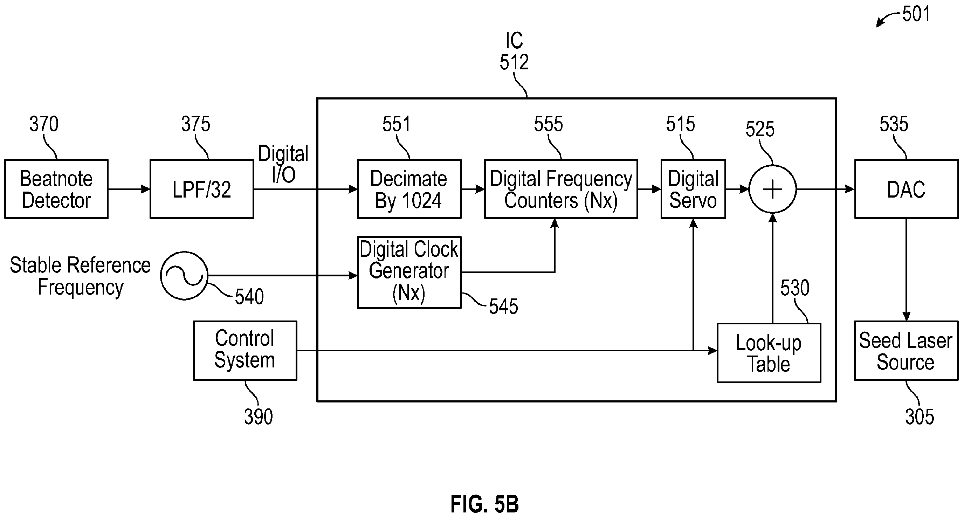

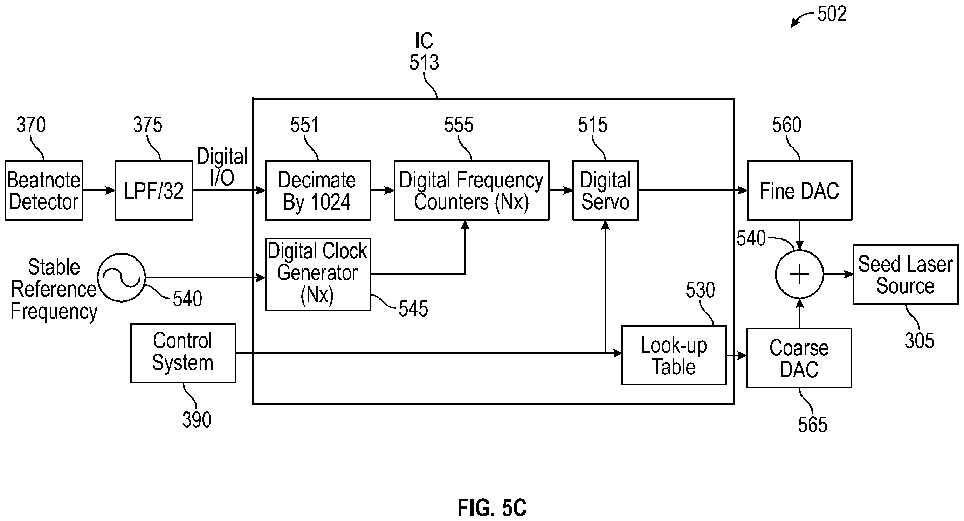

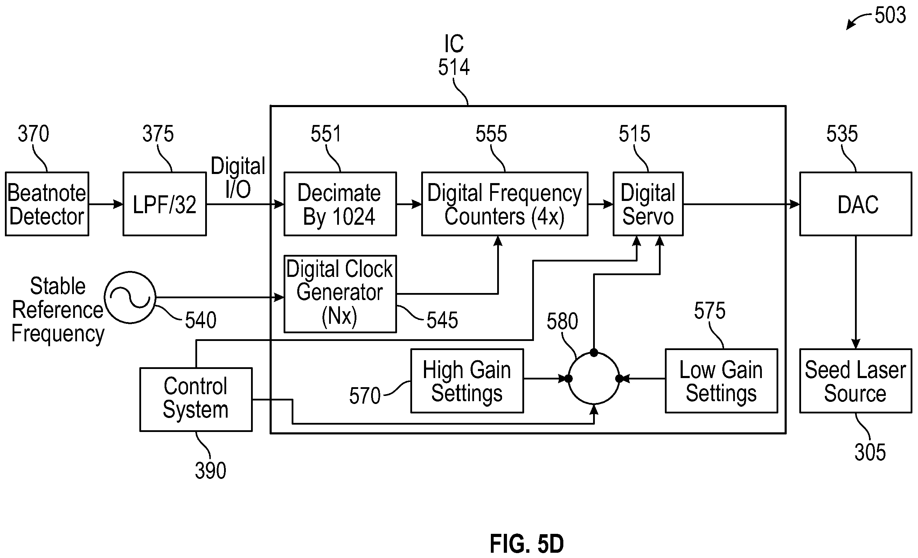

Further, as will be discussed in more detail below in Figures 5-6, the circuitry implementing the PLL servo 380 can enable other advanced features such as changing the reference frequency of the phase sensitive detection at the instant a frequency jump is required.

While the control system 390, the PLL servo 380 and the servo 325 are shown as separate elements, in one embodiment, a single control system (e.g., a control system in an integrated circuit such as an FPGA) may perform the functions of these elements. In this example, both the seed and the reference laser sources 305, 310 are controlled by the same control system.

Figure 4 illustrates frequency agility for a laser used for laser-cooling atomic techniques, according to one embodiment. Figure 4 illustrates an optical system 400 that includes a 1560 nm seed laser with a 780 nm reference laser. As discussed above, a doubler is used to convert the 1560 nm optical signal to a 780 nm optical signal which is then compared to the 780 nm reference laser by an offset beatnote which determines an offset between the doubled 780 nm optical signal provided by the frequency doubler and the 780 nm reference optical signal generated by the 780 nm reference laser. The offset beatnote can be implemented using any of the techniques discussed above to perform frequency transitions as part of frequency agility.

A chart 405 lists the desired offsets between the doubled 780 nm optical signal and the 780 nm reference optical signal for a plurality of stages in a laser-cooling atomic application. Each stage (i.e., Magneto-Optical Trap (MOT), Polarization Gradient Cooling (PGC), de-pumping, Raman, and Detection) has a different offset (i.e., detuning frequency). The graph 410 illustrates the detuning frequencies for the stages in the chart 405 as well as the lock frequency. Plot 415 illustrates the saturated absorption spectra of ⁸⁷Rb and ⁸⁵Rb at 780 nm, where the sharp resonances correspond to different hyperfine levels superimposed on the Doppler broadened absorption peaks. The dashed plot 420 illustrates the resultant error signals obtained by demodulating the laser intensity through the cell at the laser modulation frequency. The sharp dispersive resonances with zero crossings at the resonance peaks are used to lock the reference laser 310 in Figure 3 to the atomic transition of interest.

Figure 5A is a block diagram 500 for changing laser frequency using feed forwarding, according to one embodiment. In one embodiment, changing the laser frequency to perform frequency agility can be accomplished by changing the reference frequency of the phase sensitive detection at the moment a frequency change is demanded. The servo circuitry (e.g., the PLL servo 380 in Figure 3) detects the discrepancy between the reference frequency and the beatnote frequency between the lasers and adjusts the seed laser source 305 to make the beatnote offset the same as the reference frequency. However, this solution may not be sufficient due to the finite speed of the servo circuitry, which can lead to a response that may take several milliseconds depending on the servo architecture. This limitation can be mitigated somewhat by increasing the servo gain and speed, but at some point this leads to an unstable servo. For example, in the case of a very narrow-linewidth 1560 nm extended cavity laser source with an approximately 1 kHz linewidth, it is undesirable to lock the laser to the 780 nm semiconductor laser source with a high servo gain, since the high gain transfers the excess frequency noise of the 780 nm laser source (which has an approximately! MHz linewidth) to the narrow 1560 nm optical signal.

To provide a low servo gain so the reference laser source does not transfer noise to the optical signal output by the seed reference source but still performs quick (e.g., within 100 microseconds) frequency changes, Figure 5A illustrates a feedforward path 550 in the locking electronics where a previously measured and known offset to the servo output is summed to the servo output at the instant the reference frequency is changed.

Figure 5A includes the beatnote detector 370 and the frequency divider 375 which were discussed in Figure 3. The electrical output of the frequency divider 375 is received at an analog to digital converter (ADC) 505 which provides a digital input to an IC 511 (e.g., an ASIC or FPGA).

The IC 511 includes a phase/frequency (P/F) detector 510 that receives the digital signal from the ADC representing the offset between the doubled optical signal and the reference optical signal. The P/F detector 510 is also coupled to a direct digital synthesis (DDS) circuit 520 (or more generally, a waveform generator circuit) which provides an internal reference frequency (e.g., an electronic waveform) based on an instruction from the control system 390. That is, the control system 390 may send a frequency value that instructs the DDS 620 to about a specific frequency. The P/F detector 510 then submits a control signal to a digital servo 515 to adjust the seed laser source 305.

However, as discussed above, relying solely on the internal reference frequency to perform a frequency jump can lead to a response that may take several milliseconds, rather than the preferred 100 microseconds, to complete. As such, the IC 511 also includes a look-up table 530 (e.g., a memory) that is part of a feedforward path 550 where a previously measured and known offset to the output of the digital servo 515 is stored. The offset provided by the look-up table 530 is then summed to the output of the digital servo 515 using an adder 525.

In one embodiment, the control system 390 provides a selection signal to the look-up table at the instant the internal reference frequency is changed at the DDS 520. That is, when the control system 390 determines a laser frequency jump should be performed, the system 390 updates the internal reference frequency using the DDS 520 as well as selects the offset value from the look-up table 530 that corresponds to the frequency output by the DDS 520. The look-up table 530 then outputs the known offset of the digital servo 515 so it is added and then sent to a DAC 535. Thus, the feedforward path 550 means the circuitry does not have to wait for the internal reference frequency provided by the DDS 520 to propagate through the P/F detector 510 and the digital servo 515 before having an impact on the seed laser source 305. Instead, the look-up table 530 can provide the offset value near instantaneously. Put differently, the offset value ensures that the laser frequency jumps to near the requested value very quickly, independent of the servo dynamics of the digital servo 515. The offset value is then summed to the output of the digital servo 515, converted to an analog signal by the DAC 535, and used to adjust the frequency of the seed laser source 305 to result in the desired frequency change or jump.

The look-up table 530 can store the previously measured and known offsets of the output of the digital servo 515 for multiple different frequency changes or jumps. That is, the offset values for multiple frequency jumps can be predetermined and stored in the look-up table 530. For example, the look-up table 530 can store offsets corresponding to the stages and detuning frequencies illustrated in the chart 405 of Figure 4. Thus, when switching between two stages, the control system 390 can select the offset corresponding to the new stage from the look-up table to change the frequency of the seed laser source 305 according to the detuning frequency. Further, the offset values can be updated periodically by monitoring the average output values of the digital servo 515.

Figure 5B is a block diagram 501 for changing the laser frequency without using an ADC and phase-frequency detector. The divided beatnote signal generated by the beatnote detector 370 and the divider 375 is digitized using a single digital I/O line of an IC 511 (i.e. FPGA), which switches between the high and low state of the digital circuitry at every zero crossing of the incoming signal. In order to count frequency cycles of the signal, a digital frequency counter 555 is used. This topology removes a highspeed ADC from the system (which consumes a lot of power). Moreover, digital frequency counters 555 are much simpler to implement and have a larger dynamic range in comparison to the phase frequency detector in Figure 5A.

However, the digital frequency counter 555 can have resolution issues since the smallest timer interval that can be measured is one over the reference clock frequency driving the counter. For example, for a reference clock frequency of 100 MHz, and an incoming beatnote frequency of 50 MHz, the fractional frequency resolution is 50MHz/1 00MHz = 0.5, which gives only an absolute frequency resolution of 50 MHz * 0.5 = 25 MHz.

In order to improve the resolution, several different strategies can be employed. In one embodiment, the reference frequency generated by a signal generator 540 is internally multiplied up to as high as the digital platform allows. In one embodiment, a 100 MHz reference clock is multiplied up to 400 MHz inside the IC 511. This provides an additional 4x resolution. Second, a digital clock generator 545 generates N 400 MHz clocks that are 360/N degrees out of phase with each other. The digitized beatnote signal is counted by N different digital frequency counters 555 and the output of the counters are averaged. This provides an additional Nx resolution. In one embodiment, N=4, where 4 clocks 90 degrees out of phase with each other (i.e., clock 1 =0 deg, clock2=90 deg, clock3=180 deg, clock 4=270 deg) reference 4 separate digital counters 555. The averaged output has 4x the resolution. Returning to the earlier example, the frequency resolution is 50 MHz *0.25*0.25 = 3.125 MHz. As mentioned above, depending on available computing resources in the IC 511 (e.g., the availability of an FPGA fabric), the number of clocks and counters can be increased further to improve the resolution.

In applications where compute resources in the IC 511 are limited, and the servo bandwidth can be slower, further resolution improvement can be achieved by decimating the incoming signal by M using a decimator 551, which generates a new frequency M times smaller than the beatnote frequency in phase with it and tracks its frequency fluctuations. This decimation effectively allows the counter to count M cycles of the original frequency, which improves the measurement precision by 1/M. In one embodiment, M=1024, such that a 50 MHz beatnote frequency received at the decimator 551 is turned into a 50 MHz/1024 ≈ 48.8 kHz signal. In this case, the frequency resolution of the above example is further increased to 50 MHz *0.25*0.25 /1024≈ 3 kHz. Now, the digital servo 515 receives error signal updates at 48.8 kHz instead of the original 50 MHz, which will reduce the servo bandwidth accordingly. In applications, where frequency jumps in ~1 ms are acceptable, this servo bandwidth is sufficient.

In applications, where a much higher frequency resolution is required, a tapped-delay line frequency counter can be used as the digital frequency counter 555 to increase the resolution by 1000x without decrease in the processing bandwidth. Such a counter may be implemented on the IC 511, or an external dedicated time-to-digital converter (TDC) IC.

Similar to Figure 5A, a look up table 530 is used to provide offsets to the output of the digital servo 515 when a laser frequency jump is required. During a frequency jump, the control system 390 selects the appropriate offset voltage as well as updates the setpoint of the digital servo 515 to the new offset frequency. Once the digital servo 515 is stabilized, the look up table 530 may be updated by the control system 390 with the average servo output to facilitate future laser frequency jumps.

In another embodiment, the digital servo 515 in Figures 5A, 5B, and 5C can have an additional hold feature, which is useful during large frequency jumps in minimizing servo under or overshoots during the transition. When a frequency jump is commanded, the control system 390 puts the digital servo 515 into a hold state, which freezes the output at the last value. Then the frequency jump is initiated with a change in the look-up table 530. After a pre-determined settling time, or some threshold condition on the servo error signal, the control system 390 disables the hold and the servo 515 is reactivated.

Figure 5C is a block diagram 502 that includes an IC 513 for changing the laser frequency in applications where frequency jumps are very large such that the required DAC voltage resolution and dynamic range cannot be simultaneously met. In this case, a coarse/fine DAC topology can be utilized at the output. A high resolution, but limited dynamic range DAC (fine DAC 560) can be used to convert the output of the digital servo 515 into an analog voltage, while a coarse, large dynamic range DAC (coarse DAC 565) can be used to convert the value output by the look up table 530 into an analog voltage. These two analog signals are summed in the analog domain before they are sent to the seed laser source 305.

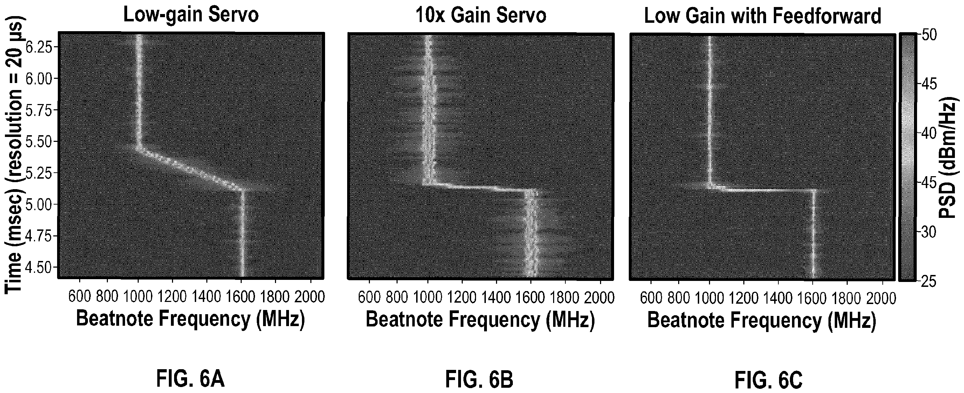

Figure 5D is a block diagram 503 that includes an IC 514 for changing the laser frequency that does not utilize a look-up table for a servo output offset. Instead, the parameters of the digital servo 515 are dynamically adjusted depending on whether the laser is dwelling at a specific frequency or commanded to jump to a new frequency. As shown in Figures 6A-6C below, the transition time can be reduced by increasing the gain of the digital servo 515, at the expense of servo stability. During frequency jumps, the control system 390 selects the high gain settings 570 stored in memory, as well as send the appropriate setpoint to the servo 515, in order to accomplish the jump as quickly as possible. After a predetermined settling time, or some threshold condition on the servo error signal, the gain settings are switched back to low-gain settings 575 optimized for the lowest residual servo error signal noise. The control system 390 can control the selection of the high gain settings 570 and the low gain settings 575 using a switch 580.

This architecture is not limited to the digital frequency counter scheme shown in Figure 5D but can also be implemented with the phase-frequency detector approach illustrated in Figure 5A. Further, the architecture in Figure 5D can be combined with the lookup table approach used in Figures 5A-5C to control the digital servo 515, and thus, the implementation shown in Figure 5D is not mutual exclusive with using the look-up table 530 in Figures 5A-5C.

Figures 6A-6C illustrate advantages of changing laser frequency using feed forwarding, according to one embodiment. Figures 6A-6C illustrate real-time spectrum analyzer traces of an offset frequency between the reference laser and the seed laser when performing a frequency jump. In this experiment, a 1560 nm DFB seed laser and a 780 nm reference laser were used but the seed laser has a linewidth that was two times lower than the reference laser.

Figure 6A illustrates using a low gain servo system to execute a 640 MHz jump in the beatnote signal. This change in frequency between the seed and reference optical signals takes approximately 400 microseconds to execute. Figure 6B illustrates increasing the servo gain by 10 times the servo gain used in Figure 6A. Now the jump takes approximately 50 microseconds, but the lock is unstable which is shown by the "ringing" in the beatnote signal.

Figure 6C illustrates using a low gain servo like with Figure 6A but with the addition of the feedforward path 550 in Figure 5A. This illustrates a jump that takes approximately 50 microseconds (or less) and a stable lock. Thus, using a feedforward path enables quick frequency changes like a high-gain servo but without the lock between the seed and reference laser source becoming unstable.

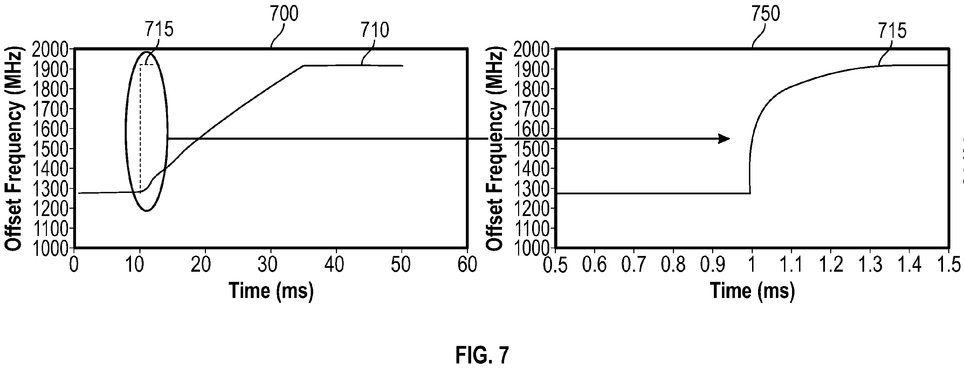

Figure 7 illustrates an effect of feed forwarding on a laser frequency transition, according to one embodiment. The chart 700 in Figure 7 illustrates performing the same experiment as in Figures 6A-6C but with a seed optical signal with a narrow linewidth of 1kHz. Here the servo bandwidth is reduced to less than 1 kHz to avoid deterioration of the linewidth. Consequently, the jump time is 25 ms for the same 640 MHz jump without using the feedforward path as shown by plot 710. The plot 715 is the result of

performing the same experiment but enabling the feedforward path which can reduce the jump time to approximately 300 microseconds, which is sufficient for highly sensitive experiments with long interrogation times that use lasers with narrow linewidths. The graph 750 illustrates a zoomed in view of the plot 715.

The preceding description is provided to enable any person skilled in the art to practice the various embodiments described herein. The examples discussed herein are not limiting of the scope, applicability, or embodiments set forth in the claims. Various modifications to these embodiments will be readily apparent to those skilled in the art, and the generic principles defined herein may be applied to other embodiments. For example, changes may be made in the function and arrangement of elements discussed without departing from the scope of the disclosure. Various examples may omit, substitute, or add various procedures or components as appropriate. For instance, the methods described may be performed in an order different from that described, and various steps may be added, omitted, or combined. Also, features described with respect to some examples may be combined in some other examples. For example, an apparatus may be implemented or a method may be practiced using any number of the aspects set forth herein. In addition, the scope of the disclosure is intended to cover such an apparatus or method that is practiced using other structure, functionality, or structure and functionality in addition to, or other than, the various aspects of the disclosure set forth herein. It should be understood that any aspect of the disclosure disclosed herein may be embodied by one or more elements of a claim.

As used herein, the word "exemplary" means "serving as an example, instance, or illustration." Any aspect described herein as "exemplary" is not necessarily to be construed as preferred or advantageous over other aspects.

As used herein, a phrase referring to "at least one of" a list of items refers to any combination of those items, including single members. As an example, "at least one of: a, b, or c" is intended to cover a, b, c, a-b, a-c, b-c, and a-b-c, as well as any combination with multiples of the same element (e.g., a-a, a-a-a, a-a-b, a-a-c, a-b-b, a-c-c, b-b, b-b-b, b-b-c, c-c, and c-c-c or any other ordering of a, b, and c).

As used herein, the term "determining" encompasses a wide variety of actions. For example, "determining" may include calculating, computing, processing, deriving, investigating, looking up (e.g., looking up in a table, a database or another data structure), ascertaining and the like. Also, "determining" may include receiving (e.g., receiving information), accessing (e.g., accessing data in a memory) and the like. Also, "determining" may include resolving, selecting, choosing, establishing and the like.

The methods disclosed herein comprise one or more steps or actions for achieving the methods. The method steps and/or actions may be interchanged with one another without departing from the scope of the claims. In other words, unless a specific order of steps or actions is specified, the order and/or use of specific steps and/or actions may be modified without departing from the scope of the claims. Further, the various operations of methods described above may be performed by any suitable means capable of performing the corresponding functions. The means may include various hardware and/or software component(s) and/or module(s), including, but not limited to a circuit, an application specific integrated circuit (ASIC), or processor. Generally, where there are operations illustrated in figures, those operations may have corresponding counterpart means-plus-function components with similar numbering.

As will be appreciated by one skilled in the art, the embodiments disclosed herein may be embodied as a system, method, or computer program product. Accordingly, embodiments may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, embodiments may take the form of a computer program product embodied in one or more computer readable medium(s) having computer readable program code embodied thereon.

Program code embodied on a computer readable medium may be transmitted using any appropriate medium, including but not limited to wireless, wireline, optical fiber cable, RF, etc., or any suitable combination of the foregoing.

Computer program code for carrying out operations for embodiments of the present disclosure may be written in any combination of one or more programming languages, including an object oriented programming language such as Java, Smalltalk, C++ or the like and conventional procedural programming languages, such as the "C" programming language or similar programming languages. The computer program code could also include hardware description language such as Verilog or VHDL. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present disclosure are described herein with reference to flowchart illustrations and/or block diagrams of methods, apparatuses (systems), and computer program products according to embodiments presented in this disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the block(s) of the flowchart illustrations and/or block diagrams.

These computer program instructions may also be stored in a computer readable medium that can direct a computer, other programmable data processing apparatus, or other device to function in a particular manner, such that the instructions stored in the computer readable medium produce an article of manufacture including instructions which implement the function/act specified in the block(s) of the flowchart illustrations and/or block diagrams.

The computer program instructions may also be loaded onto a computer, other programmable data processing apparatus, or other device to cause a series of operational steps to be performed on the computer, other programmable apparatus or other device to produce a computer implemented process such that the instructions which execute on the computer, other programmable data processing apparatus, or other device provide processes for implementing the functions/acts specified in the block(s) of the flowchart illustrations and/or block diagrams.

The flowchart illustrations and block diagrams in the Figures illustrate the architecture, functionality, and operation of possible implementations of systems, methods, and computer program products according to various embodiments. In this regard, each block in the flowchart illustrations or block diagrams may represent a module, segment, or portion of code, which comprises one or more executable instructions for implementing the specified logical function(s). It should also be noted that, in some alternative implementations, the functions noted in the block may occur out of the order noted in the Figures. For example, two blocks shown in succession may, in fact, be executed substantially concurrently, or the blocks may sometimes be executed in the reverse order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

The following claims are not intended to be limited to the embodiments shown herein, but are to be accorded the full scope consistent with the language of the claims. Within a claim, reference to an element in the singular is not intended to mean "one and only one" unless specifically so stated, but rather "one or more." Unless specifically stated otherwise, the term "some" refers to one or more. No claim element is to be construed under the provisions of 35 U.S.C. §112(f) unless the element is expressly recited using the phrase "means for" or, in the case of a method claim, the element is recited using the phrase "step for." All structural and functional equivalents to the elements of the various aspects described throughout this disclosure that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims.

Further embodiments:
Embodiment 1. An optical system, comprising:
   a seed laser source configured to output a first optical signal with a first wavelength;
   a frequency adjuster configured to receive the first optical signal and output an adjusted first optical signal with a second wavelength;
   a reference laser source configured to output a second optical signal with a third wavelength, wherein the first wavelength is different than the third wavelength;
   an atomic reference configured to receive the second optical signal and output a control signal to the reference laser source that locks the second optical signal to the third wavelength; and
   a controller configured to adjust the first optical signal based on comparing the adjusted first optical signal to the second optical signal.
Embodiment 2. The optical system of embodiment 1, wherein the first wavelength is approximately an integer multiple of the third wavelength.
Embodiment 3. The optical system of embodiment 2, wherein the integer multiple is two.
Embodiment 4. The optical system of embodiment 3, wherein the first wavelength is approximately 1560 nm and the third wavelength is approximately 780 nm.
Embodiment 5. The optical system of embodiment 1, further comprising:
   a beatnote detector configured to receive the adjusted first optical signal and the second optical signal and output an error signal to the controller indicating a difference between wavelengths of the adjusted first optical signal and the second optical signal.
Embodiment 6. The optical system of embodiment 5, further comprising:
   a splitter coupled to an output of the frequency adjuster, wherein the splitter is configured to transmit a first portion of the power of the adjusted first optical signal to an output of the optical system and a second portion of the power of the adjusted first optical signal to the beatnote detector.
Embodiment 7. The optical system of embodiment 1, wherein the atomic reference comprises a gas cell configured to be used to perform laser spectroscopy to lock the second optical signal to the third wavelength.
Embodiment 8. The optical system of embodiment 1, wherein the controller is configured to adjust the first wavelength of the first optical signal to perform a frequency jump that results in a desired frequency offset between the adjusted first optical signal and the second optical signal.
Embodiment 9. A method, comprising:
   generating, using an optical source, a first optical signal having a first wavelength;
   adjusting the wavelength of the first optical signal to generate an adjusted first optical signal having a second wavelength;
   comparing the adjusted first optical signal to a second optical signal, wherein the second optical signal is locked to an atomic reference at a third wavelength; and
   adjusting the optical source to change the first wavelength of the first optical signal based on comparing the adjusted first optical signal to the second optical signal.
Embodiment 10. The method of embodiment 9, wherein the first wavelength is approximately an integer multiple of the third wavelength.
Embodiment 11. The method of embodiment 10, wherein the integer multiple is two.
Embodiment 12. The method of embodiment 9, wherein comparing the adjusted first optical signal to the second optical signal is performed using a beatnote detector that outputs an error signal indicating a difference between wavelengths of the adjusted first optical signal and the second optical signal.
Embodiment 13. The method of embodiment 12, further comprising:
   splitting the adjusted first optical signal such that a first portion of the power of the adjusted first optical signal is transmitted to a downstream system and a second portion of the power of the adjusted first optical signal is transmitted to the beatnote detector.
Embodiment 14. The method of embodiment 9, further comprising: performing laser spectroscopy using a gas cell to lock the second optical signal to the third wavelength.
Embodiment 15. The method of embodiment 9, further comprising:
   adjusting the first wavelength of the first optical signal to perform a frequency jump that results in a desired frequency offset between the adjusted first optical signal and the second optical signal.
Embodiment 16. A system, comprising:
   an input configured to receive an error signal indicating a difference between wavelengths of a first optical signal and a second optical signal;
   a control system configured to output instructions to perform a frequency jump to change a frequency of the first optical signal relative to a frequency of the second optical signal;
   a digital frequency counter configured to count frequency cycles of the error signal;
   a digital servo configured to generate an adjustment signal based on the frequency cycles counted by the digital frequency counter; and
   a feedforward path configured to generate an offset corresponding to a frequency value received from the control system, and
   wherein the system is configured to use the offset from the feedforward path and the adjustment signal from the digital servo to output a modified adjustment signal for adjusting an optical source generating the first optical signal to perform the frequency jump.
Embodiment 17. The system of embodiment 16, wherein the input comprises a decimater that decimates the error signal before the error signal reaches the digital frequency counter.
Embodiment 18. The system of embodiment 16, wherein the digital frequency counter comprises a tapped-delay line frequency counter.
Embodiment 19. The system of embodiment 16, wherein the feedforward path comprises:
   a look up table storing a plurality of offsets corresponding to different frequency jumps, wherein the look up table selects which of the plurality of offsets to output in response to different instructions received from the control system,
   wherein an output of the look up table is coupled to a coarse digital to analog converter (DAC) and an output of the digital servo is coupled to a fine DAC, wherein outputs of the coarse and fine DACs are coupled to an adder, and wherein the modified adjustment signal is based on an output of the adder.
Embodiment 20. The system of embodiment 16, wherein digital servo comprises a hold feature where the control system can temporarily freeze an output of the digital servo before performing the frequency jump.
Embodiment 21. The system of embodiment 16, wherein feedforward path comprises low gain settings and high gain settings stored in memory for generating the offset, wherein the offset is provided to the digital servo, and wherein the control system is configured to switch from the low gain settings to the high gain setting to perform the frequency jump.
Embodiment 22. The system of embodiment 16, further comprising:
   a signal generator configured to output a reference signal;
   a digital clock generator coupled to the signal generator and configured to generate N number of clocks based on the reference signal that are 360/N degrees out of phase with each other;
   a plurality of digital frequency counters, which includes the digital frequency counter, configured to each receive one of the N number of clocks, wherein an input of the digital servo is a based on a combination of the outputs of the plurality of digital frequency counters.

## Claims

1. An optical system, comprising:
a seed laser source configured to output a first optical signal with a first wavelength;
a frequency adjuster configured to receive the first optical signal and output an adjusted first optical signal with a second wavelength;
a reference laser source configured to output a second optical signal with a third wavelength, wherein the first wavelength is different than the third wavelength;
an atomic reference configured to receive the second optical signal and output a control signal to the reference laser source that locks the second optical signal to the third wavelength; and
a controller configured to adjust the first optical signal based on comparing the adjusted first optical signal to the second optical signal.

2. The optical system of claim 1, wherein the first wavelength is approximately an integer multiple of the third wavelength.

3. The optical system of claim 2, wherein the integer multiple is two, and especially wherein the first wavelength is approximately 1560 nm and the third wavelength is approximately 780 nm.

4. The optical system of claim 1, further comprising:
a beatnote detector configured to receive the adjusted first optical signal and the second optical signal and output an error signal to the controller indicating a difference between wavelengths of the adjusted first optical signal and the second optical signal; and especially further comprising:
a splitter coupled to an output of the frequency adjuster, wherein the splitter is configured to transmit a first portion of the power of the adjusted first optical signal to an output of the optical system and a second portion of the power of the adjusted first optical signal to the beatnote detector.

5. The optical system of claim 1, wherein the atomic reference comprises a gas cell configured to be used to perform laser spectroscopy to lock the second optical signal to the third wavelength.

6. The optical system of claim 1, wherein the controller is configured to adjust the first wavelength of the first optical signal to perform a frequency jump that results in a desired frequency offset between the adjusted first optical signal and the second optical signal.

7. A method, comprising:
generating, using an optical source, a first optical signal having a first wavelength;
adjusting the wavelength of the first optical signal to generate an adjusted first optical signal having a second wavelength;
comparing the adjusted first optical signal to a second optical signal, wherein the second optical signal is locked to an atomic reference at a third wavelength; and
adjusting the optical source to change the first wavelength of the first optical signal based on comparing the adjusted first optical signal to the second optical signal.

8. The method of claim 7, wherein the first wavelength is approximately an integer multiple of the third wavelength; especially wherein the integer multiple is two.

9. The method of claim 7, wherein comparing the adjusted first optical signal to the second optical signal is performed using a beatnote detector that outputs an error signal indicating a difference between wavelengths of the adjusted first optical signal and the second optical signal; and
especially further comprising:
splitting the adjusted first optical signal such that a first portion of the power of the adjusted first optical signal is transmitted to a downstream system and a second portion of the power of the adjusted first optical signal is transmitted to the beatnote detector.

10. The method of claim 7, further comprising:
performing laser spectroscopy using a gas cell to lock the second optical signal to the third wavelength; or
further comprising:
adjusting the first wavelength of the first optical signal to perform a frequency jump that results in a desired frequency offset between the adjusted first optical signal and the second optical signal.

11. A system, comprising:
an input configured to receive an error signal indicating a difference between wavelengths of a first optical signal and a second optical signal;
a control system configured to output instructions to perform a frequency jump to change a frequency of the first optical signal relative to a frequency of the second optical signal;
a digital frequency counter configured to count frequency cycles of the error signal;
a digital servo configured to generate an adjustment signal based on the frequency cycles counted by the digital frequency counter; and
a feedforward path configured to generate an offset corresponding to a frequency value received from the control system, and
wherein the system is configured to use the offset from the feedforward path and the adjustment signal from the digital servo to output a modified adjustment signal for adjusting an optical source generating the first optical signal to perform the frequency jump.

12. The system of claim 11, wherein the input comprises a decimater that decimates the error signal before the error signal reaches the digital frequency counter; or
wherein the digital frequency counter comprises a tapped-delay line frequency counter; or
wherein digital servo comprises a hold feature where the control system can temporarily freeze an output of the digital servo before performing the frequency jump.

13. The system of claim 11, wherein the feedforward path comprises:
a look up table storing a plurality of offsets corresponding to different frequency jumps, wherein the look up table selects which of the plurality of offsets to output in response to different instructions received from the control system,
wherein an output of the look up table is coupled to a coarse digital to analog converter (DAC) and an output of the digital servo is coupled to a fine DAC, wherein outputs of the coarse and fine DACs are coupled to an adder, and wherein the modified adjustment signal is based on an output of the adder.

14. The system of claim 11, wherein feedforward path comprises low gain settings and high gain settings stored in memory for generating the offset, wherein the offset is provided to the digital servo, and wherein the control system is configured to switch from the low gain settings to the high gain setting to perform the frequency jump.

15. The system of claim 11, further comprising:
a signal generator configured to output a reference signal;
a digital clock generator coupled to the signal generator and configured to generate N number of clocks based on the reference signal that are 360/N degrees out of phase with each other;
a plurality of digital frequency counters, which includes the digital frequency counter, configured to each receive one of the N number of clocks, wherein an input of the digital servo is a based on a combination of the outputs of the plurality of digital frequency counters.
